# EUROPÄISCHE PATENTSCHRIFT

(11) **EP 0 398 108 B1**
(45) Veröffentlichungstag und Bekanntmachung des Hinweises auf die Patenterteilung: **22.12.1993**
(21) Anmeldenummer: 90108516.7
(22) Anmeldetag: 07.05.1990
(51) Int. Cl.: H01L 23/24, H01L 23/053, H01L 23/04

(54) **Kunststoffgehäuse und Leistungshalbleitermodul mit diesem Gehäuse**
Plastic housing and semiconductor power module having this housing
Boîtier en plastique et module semi-conducteur de puissance comprenant ce boîtier

(30) Priorität: 13.05.1989 DE 3915707
(43) Veröffentlichungstag der Anmeldung: 22.11.1990
(73) Patentinhaber: Asea Brown Boveri Aktiengesellschaft, 68309 Mannheim (DE)
(72) Erfinder: Neidig, Arno, Dr., D-6831 Plankstadt (DE)
(74) Vertreter: Rupprecht, Klaus, Dipl.-Ing.

(56) Entgegenhaltungen:
- EP-A- 0 069 901
- FR-A- 2 535 898
- PATENT ABSTRACTS OF JAPAN, Band 10, Nr. 209 (E-421)[2265], 22. Juli 1986; & JP-A-61 48 947
- PATENT ABSTRACTS OF JAPAN, Band 9, Nr. 212 (E-339)[1935], 29. August 1985; & JP-A-60 74 655
- PATENT ABSTRACTS OF JAPAN, Band 11, Nr. 23 (E-473)[2470], 22. Januar 1987; & JP-A-61 193 471
- PATENT ABSTRACTS OF JAPAN, Band 9, Nr. 325 (E-368)[2048], 20. Dezember 1985; & JP-A-60 157 241

## Beschreibung

Die Erfindung bezieht sich auf ein Kunststoffgehäuse für ein Leistungshalbleitermodul sowie auf ein Leistungshalbleitermodul, das unter Verwendung dieses Kunststoffgehäuses hergestellt ist.

Ein Leistungshalbleitermodul mit einem Kunststoffgehäuse ist aus der DE-PS 31 27 457 bekannt. Dort ist ein rahmenförmiges Kunststoffgehäuse dargestellt, in welches als Gehäuseboden ein mit einer Metallschicht versehenes Keramiksubstrat mit einem elastischen Klebstoff eingeklebt ist. Das Innere des Gehäuses ist zuerst mit einer weichen Vergußmasse aus Silikonkautschuk bis etwa zur Hälfte der Gehäusehöhe vergossen. Darüber ist eine harte Vergußmasse aus Epoxidharz bis zum oberen Rand des Gehäuses eingefüllt. Die harte Vergußmasse verleiht dem Modul mechanische Stabilität und fixiert auch mit Anschlußlaschen bezeichnete Flachstecker für den elektrischen Anschluß.

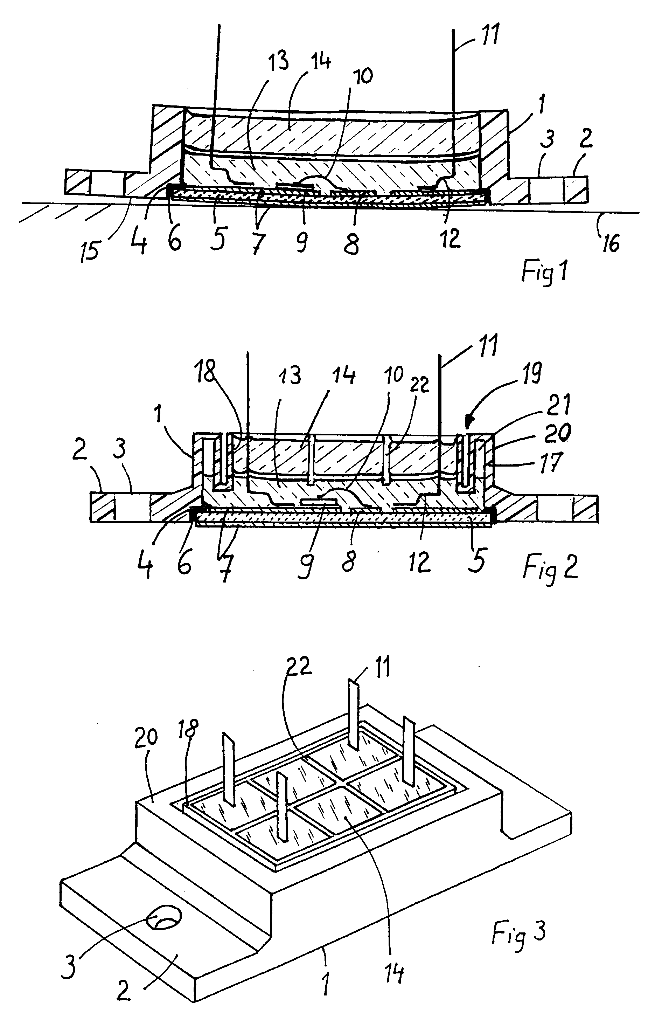

Ein solches bekanntes Leistungshalbleitermodul ist in Fig. 1 der Zeichnung dargestellt. Aus dieser Darstellung ist zu entnehmen, daß die Bodenfläche des fertiggestellten Moduls eine starke konvexe Wölbung aufweist. Die Ursache für die Verformung des Moduls ist in einer Schrumpfung des Epoxidharzes nach dem Einfüllen und während eines Aushärteprozesses zu sehen. Je nach Harztyp ist eine Volumenreduzierung im Bereich von einigen Zehntel Prozent des Volumens gegeben. Außerdem ist der thermische Ausdehnungskoeffizient des Epoxidharzes wesentlich höher als der von Metallen oder Keramik. Der Ausdehnungskoeffizient liegt je nach Füllgrad mit anorganischen Stoffen, wie Quarzmehl, Aluminiumoxid oder Dolomit zwischen 35 · 10⁻⁶ K⁻¹ und 100 · 10⁻⁶ K⁻¹. Nach dem Aushärten und Abkühlen des Moduls von etwa 130°C auf Raumtemperatur kommt es daher zu einer im Vergleich zum Keramiksubstrat starken Schrumpfung des Gehäuses im oberen Teil des Moduls. Dies führt zu einer starken Verformung des Gehäuses. Außerdem wird das Keramiksubstrat ebenfalls verformt, weil die mechanischen Spannungen vom Epoxidharz teils über die Flachstecker und teils über die Klebung auf das Substrat übertragen werden.

Zwar kann eine geringe konvexe Verformung durchaus erwünscht sein, wenn ein solches Modul unter Verwendung einer Wärmeleitpaste auf einen Kühlkörper montiert wird. Dann wird nämlich ein guter Andruck erzielt und es wird die Wärmeleitpaste von innen nach außen verdrängt, wobei die Wärmeleitpaste dünn verteilt wird und somit ein wünschenswert niedriger Übergangswiderstand erreicht wird. Diese gleichmäßige Auflage des Moduls tritt jedoch bei starker Verformung des Moduls nicht ein. Wird das Modul durch die Montage auf einen Kühlkörper zwangsweise in eine ebene Form gebracht, so können Risse am Gehäuse oder dem Keramiksubstrat auftreten und das Epoxidharz kann sich von der Gehäusewand ablösen, wodurch eine Abdichtung nicht mehr gegeben ist.

Erhebliche Modulverformungen treten insbesondere bei flachen Modulen auf, also bei Modulen, deren Gehäuserahmen nur eine geringe Höhe aufweisen im Verhältnis zur Länge oder Breite des Moduls. Als störend kann sich beispielsweise bei einer Substratlänge von 50 mm bereits eine Verwölbung von 200 µm erweisen.

Der Erfindung liegt die Aufgabe zugrunde, ein Kunststoffgehäuse für Leistungshalbleitermodule und eine geeignete Modulgestaltung anzugeben, mit denen eine unzulässige Verwölbung des Modulbodens vermieden werden kann können.

Diese Aufgabe wird durch ein Kunststoffgehäuse mit einer balgenartigen Faltung der Gehäusewand gelöst, wobei durch die Faltung eine innere Gehäusewand und eine äußere Gehäusewand gebildet sind, die über den Balg miteinander verbunden sind. Vorteilhafte Ausgestaltungen des Gehäuses sind in Unteransprüchen und in der Beschreibung der Ausführungsbeispiele angegeben. Außerdem wird die Aufgabe durch ein Leistungshalbleitermodul mit einem solchen erfindungsgemäßen Kunststoffgehäuse gelöst, wobei das Leistungshalbleitermodul ein keramisches Substrat aufweist, das als Gehäuseboden in das Kunststoffgehäuse eingesetzt ist und wobei das Substrat wenigstens auf der dem Gehäuseinneren zugewandten Seite wenigstens auf Teilflächen eine Metallschicht aufweist, auf der zumindest ein Leistungshalbleiterbauelement aufgelötet ist. Die mit der Erfindung vorgeschlagene Ausführung des Kunststoffgehäuses hat den Vorteil, daß eine nachgiebige innere Gehäusewand der Schrumpfung der Hartvergußmasse folgen kann, während eine starre äußere Gehäusewand praktisch unverformt bleibt. Innere und äußere Wände sind durch eine balgenartige Faltung miteinander verbunden, wodurch das Kunststoffgehäuse vorteilhaft in einem Spritzgußvorgang einstückig hergestellt werden kann. Die Faltung gewährleistet die gewünschte obere Abdichtung und kann außerdem so ausgeführt werden, daß eine Kammer gebildet wird, die als Dehnungsausgleichsvolumen für die Weichvergußmasse wirkt.

Mechanische Druck- und Zugkräfte zwischen dem inneren Hartvergußbereich und dem Keramiksubstrat werden zweckmäßig durch eine besondere Gestaltung der Anschlußlaschen mit einem Dehnungsausgleichsbogen aufgefangen.

Als Modulboden wird bevorzugt ein keramisches Substrat verwendet, das nach einem Direktverbindungsverfahren mit einer Metallfolie verbunden ist. Eine ausführliche Beschreibung der Erfindung erfolgt anhand von in der Zeichnung dargestellten Ausführungsbeispielen.

Es zeigen:
- Fig. 1: Schnitt durch ein Leistungshalbleitermodul mit einem Kunststoffgehäuse nach dem Stand der Technik,
- Fig. 2: Schnitt durch ein Leistungshalbleitermodul mit einem erfindungsgemäßen Kunststoffgehäuse, an welches Befestigungslaschen angeformt sind,
- Fig. 3: Gesamtansicht des Moduls gemäß Fig. 2, das einen rahmenförmigen inneren Gehäusewand aufweist,
- Fig. 4: ähnliches Modul wie in Fig. 3 dargestellt, jedoch mit einem haubenförmigen inneren Gehäusewand,
- Fig. 5: Schnitt durch ein Leistungshalbleitermodul mit einem erfindungsgemäßen Kunststoffgehäuse, das auf eine Metallplatte aufgeklebt ist.

Fig. 1 zeigt einen Schnitt durch ein Leistungshalbleitermodul nach dem Stand der Technik. Dabei ist ein rahmenförmiges Kunststoffgehäuse 1 dargestellt, an welches Befestigungslaschen 2 angeformt sind, die Löcher 3 zur Durchführung von Befestigungsschrauben aufweisen. In der Bodenebene des Gehäuses 1 ist eine Ausnehmung 4 vorhanden, in welcher ein keramisches Substrat 5 mit Hilfe eines elastischen Klebstoffs 6 auf Silikonbasis eingeklebt ist, so daß das Substrat 5 nahezu bündig mit der Bodenebene abschließt und nur sehr geringfügig übersteht. Das keramische Substrat 5 ist auf der Oberseite und der Unterseite mit einer metallischen Schicht 7 versehen, wobei die obere Schicht zu Leiterbahnen 8 strukturiert ist. Die metallische Schicht 7 ist als Kupferfolie mit z.B. 0,4 mm Dicke ausgeführt und nach einem Direktverbindungsverfahren aufgebracht. Auf die Leiterbahnen 8 ist wenigstens ein Leistungshalbleiterbauelement 9 in Weichlöttechnik aufgelötet. Weiterhin sind auf die Leiterbahnen 8 Metallbügel 10 für interne elektrische Verbindungen sowie Anschlußlaschen 11 für äußere elektrische Anschlüsse aufgelötet. Die Anschlußlaschen 11 sind mit einem Dehnungsausgleichsbogen 12 im unteren Bereich versehen, wobei der Querschnitt der Anschlußlaschen 11 im Bereich des Dehnungsbogens 12 geringer ist als im übrigen Bereich. Das Modul ist etwa zur Hälfte mit einer Weichvergußmasse 13 gefüllt, z.B. einem Silikongel. Das verbleibende Gehäusevolumen ist mit einer Hartvergußmasse 14 aus Epoxidharz aufgefüllt.

Das bekannte Leistungshalbleitermodul nach Fig. 1 weist eine unerwünscht starke konvexe Wölbung 15 auf, wodurch das Leistungshalbleitermodul nur punktförmig auf einer ebenen Unterlage 16 aufliegt.

In der Beschreibung der weiteren Figuren sind für übereinstimmende Bauteile jeweils die gleichen Bezugszeichen verwendet.

Fig. 2 zeigt einen Schnitt durch ein Leistungshalbleitermodul mit einem erfindungsgemäßen Kunststoffgehäuse 1. Der übrige Modulaufbau stimmt mit demjenigen der Fig. 1 überein. Das rahmenförmige Kunststoffgehäuse 1 weist eine Faltung seiner Gehäusewand 17 auf, wodurch eine innere Gehäusewand 18 und eine äußere Gehäusewand 20 gebildet sind, die über den Balg 19 miteinander verbunden sind. Die innere Gehäusewand 18 ist in der dargestellten Ausführung rahmenförmig und ist mit der Hartvergußmasse 14 ausgefüllt. Die Faltung ist vorteilhaft so ausgeführt, daß der Balg 19 mit der äußeren Gehäusewand 20 eine Kammer 21 als Dehnungsausgleichsvolumen für die Weichvergußmasse 13 bildet. Damit kann verhindert werden, daß die Weichvergußmasse 13 bei betriebsmäßiger Erwärmung einen unzulässigen Druck innerhalb des Moduls erzeugt. Der von der inneren Gehäusewand 18 umschlossene Bereich Kann durch an sich bekannte Zwischenwände 22 unterteilt werden, beispielsweise als Verstrebung oder zur Führung von Anschlußlaschen 11.

Fig. 3 zeigt eine perspektivische Darstellung einer Gesamtansicht des in Fig. 2 dargestellten und vorstehend beschriebenen Moduls.

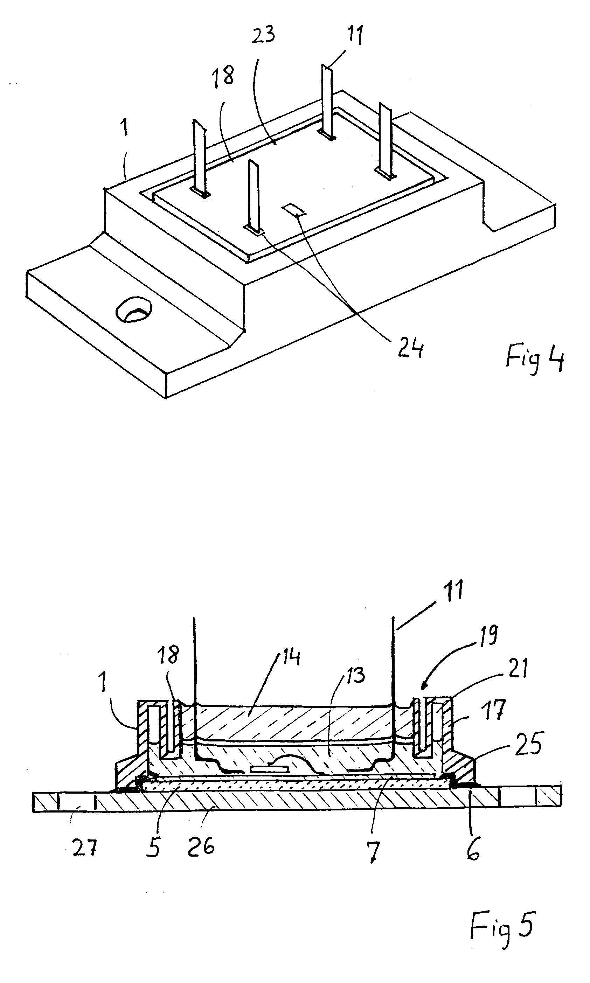

Fig. 4 zeigt eine Modulausführung, die sich durch eine Ausführung der inneren Gehäusewand 18 als Haube 23 von der in Fig. 3 gezeigten Modulausführung unterscheidet. In der Haube 23 können Öffnungen 24 zur Durchführung der Anschlußlaschen 11 oder zum Einfüllen von Vergußmasse 13, 14 (Fig. 2) vorhanden sein.

In Fig. 5 ist ein Schnitt durch eine Modulvariante mit einer massiven, mindestens 2 mm, beispielsweise 6 mm dicken Metallbodenplatte 26 dargestellt. Die Metallbodenplatte ist in bekannter Weise mit dem Substrat 5 verlötet. Die Platte 26 weist Bohrungen 27 zur Befestigung auf. Das Kunststoffgehäuse 1 ist mit Klebstoff 6 auf die Metallbodenplatte 26 aufgeklebt. Das Kunststoffgehäuse 1 ist in einem unteren Bereich 25 mindestens doppelt so dick wie die übrige Gehäusewand 17 ausgeführt, damit eine vergrößerte Flache für die Verbindung mit der Platte 26 zur Verfügung steht.

Je nach Modulgestaltung kann es ausreichen, nur zwei senkrecht zueinander stehende Wände des Kunststoffgehàuses 1 mit einer Faltung zu versehen, um den mit der Erfindung angestrebten Effekt zu erzielen.

## Patentansprüche

1. Kunststoffgehäuse mit einer Gehäusewand für ein Leistungshalbleitermodul, gekennzeichnet durch eine balgenartige Faltung der Gehäusewand (17) derart, daß durch die Faltung eine innere Gehäusewand (18) und eine äußere Gehäusewand (20) gebildet sind, die über den Balg (19) miteinander verbunden sind.

2. Kunststoffgehäuse nach Anspruch, 1, dadurch gekennzeichnet, daß die innere Gehäusewand (18) rahmenförmig ist.

3. Kunststoffgehäuse nach Anspruch 2, dadurch gekennzeichnet, daß der von der inneren rahmenförmigen Gehäusewand (18) umschlossene Bereich durch Zwischenwände (22) unterteilt ist.

4. Kunststoffgehäuse nach Anspruch 1, dadurch gekennzeichnet, daß die innere Gehäusewand (18) oben geschlossen und dadurch haubenförmig ist, wobei oben Öffnungen (23) zur Durchführung von Anschlüssen (11) oder zum Einfüllen einer Vergußmasse (13,14) vorhanden sind.

5. Rechteckiges Kunststoffgehäuse nach einem der vorstehenden Ansprüche, dadurch gekennzeichnet, daß nur zwei in rechtem Winkel zueinander angeordnete Seiten der Gehäusewand eine Faltung aufweisen.

6. Kunststoffgehäuse nach einem der vorstehenden Ansprüche, dadurch gekennzeichnet, daß an das Kunststoffgehäuse Befestigungslaschen (2) mit Löchern (3) zur Durchführung von Schrauben angeformt sind.

7. Kunststoffgehäuse nach einem der Ansprüche 1 bis 5, dadurch gekennzeichnet, daß die Gehäusewand (17) in einem unteren Bereich (25), der zur Verbindung des Kunststoffgehäuses (1) mit einem Substrat (5) als Bodenfläche vorgesehen ist, mindestens zweifach so dick ausgeführt ist, wie die übrige Gehäusewand (17).

8. Leistungshalbleitermodul mit einem Kunststoffgehäuse (1) nach einem der Ansprüche 1 bis 7 und mit einem keramischen Substrat (5), das als Gehäuseboden in das Kunststoffgehäuse (1) eingesetzt ist, wobei das Substrat (5) wenigstens auf der dem Gehäuseinneren zugewandten Seite wenigstens auf Teilflächen eine Metallschicht (7) aufweist, auf der zumindest ein Leistungshalbleiterbauelement (9) aufgelötet ist.

9. Leistungshalbleitermodul nach Anspruch 8, wobei auf der Metallschicht (7) außerdem Anschlußlaschen (11) für elektrische Anschlüsse des Moduls angelötet sind und die Anschlußlaschen (11) einen Dehnungsbogen (12) aufweisen und wobei die Anschlußlaschen (11) im Bereich des Dehnungsbogens (12) einen verringerten Querschnitt aufweisen.

10. Leistungshalbleitermodul nach Anspruch 8 oder 9, dadurch gekennzeichnet, daß die Metallschicht (7) einige Zehntel Millimeter dick ausgeführt ist und nach einem Direktverbindungsverfahren auf das keramische Substrat (5) aufgebracht ist.

11. Leistungshalbleitermodul nach einem der Ansprüche 8 bis 10, dadurch gekennzeichnet, daß das keramische Substrat (5) und das Kunststoffgehäuse (1) mit einer mindestens 2 mm dicken Metallbodenplatte (26) verbunden sind.

12. Leistungshalbleitermodul nach einem der Ansprüche 8 bis 11, dadurch gekennzeichnet, daß das Leistungshalbleitermodul zuerst mit einer Weichvergußmasse (14) bis zu einer ersten Höhe vorzugsweise der halben Gehäusehöhe ausgefüllt ist und anschließend mit einer Hartvergußmasse (13) bis zu einer zweiten Höhe, vorzugsweise bis zum oberen Rand des Gehäuses gefüllt ist.

## Claims

1. Plastic housing having a housing wall for a power semiconductor module, characterized by a bellows-like folding of the housing wall (17) in such a way that, as a result of the folding an inner housing wall (18) and an outer housing wall (20) are formed which are joined together via a bellows (19).

2. Plastic housing according to Claim 1, characterized in that the inner housing wall (18) is frame-like.

3. Plastic housing according to Claim 2, characterized in that the region enclosed by the inner, frame-like housing wall (18) is subdivided by partitions (22).

4. Plastic housing according to Claim 1, characterized in that the inner housing wall (18) is closed at the top and is consequently hood-like, openings (23) being present at the top for feeding connections (11) through or for injecting an encapsulating compound (13, 14).

5. Rectangular plastic housing according to one of the preceding claims, characterized in that only two housing-wall sides, which are arranged at a right angle to one another, have a folding.

6. Plastic housing according to one of the preceding claims, characterized in that fixing lugs (2) having holes (3) for feeding screws through are moulded onto the plastic housing.

7. Plastic housing according to one of Claims 1 to 5, characterized in that the housing wall (17) is constructed at least twice as thick as the remaining housing wall (17) in a lower region (25) which is provided for joining the plastic housing (1) to a substrate (5) as base face.

8. Power semiconductor module having a plastic housing (1) according to one of Claims 1 to 7 and having a ceramic substrate (5) which is inserted into the plastic housing (1) as housing base, in which module the substrate (5) has, at least on subareas at least on the side facing the housing interior, a metal layer (7) onto which at least one power semiconductor component (9) is soldered.

9. Power semiconductor module according to Claim 8, in which connecting lugs (11) for electrical connections of the module are additionally soldered onto the metal layer (7) and the connecting lugs (11) have an expansion bend (12), and in which the connecting lugs (11) have a reduced cross section in the region of the expansion bend (12).

10. Power semiconductor module according to Claim 8 or 9, characterized in that the metal layer (7) is formed a few tenths of a millimetre thick and is applied to the ceramic substrate (5) by a direct connection process.

11. Power semiconductor module according to one of Claims 8 to 10, characterized in that the ceramic substrate (5) and the plastic housing (1) are joined to a metal base plate (26) at least 2 mm thick.

12. Power semiconductor module according to one of Claims 8 to 11, characterized in that the power semiconductor module is first filled with a soft encapsulating compound (14) to a first height, preferably half the housing height, and is then filled with a hard encapsulating compound (13) up to a second height, preferably up to the upper rim of the housing.

## Revendications

1. Boîtier en matière plastique avec une paroi de boîtier pour un module semi- conducteur de puissance, caractérisé par un pliage en forme de soufflet de la paroi de boîtier (17) de telle manière que le pliage donne naissance à une paroi de boîtier interne (18) et à une paroi de boîtier externe (20) reliées l'une à l'autre par le soufflet (19).

2. Boîtier en matière plastique suivant la revendication 1, caractérisé par le fait que la paroi de boîtier interne ( 18) est en forme de cadre.

3. Boîtier en matière plastique suivant la revendication 2, caractérisé par le fait que la zone entourée par la paroi de boîtier interne (18) en forme de cadre est subdivisée par des parois intermédiaires (22).

4. Boîtier en matière plastique suivant la revendication 1, caractérisé par le fait que la paroi de boîtier interne (18) est fermée dans le haut et présente ainsi la forme d'une coiffe, des ouvertures (23) pour le passage de connexions (11) ou pour l'introduction d'une masse de scellement (13, 14) étant prévues dans le haut.

5. Boîtier rectangulaire en matière plastique suivant l'une des revendications précédentes, caractérisé par le fait que seuls deux côtés de la paroi de boîtier, faisant un angle droit l'un avec l'autre, présentent un pliage.

6. Boîtier en matière plastique suivant l'une des revendications précédentes, caractérisé par le fait que des pattes de fixation (2) avec des trous (3) pour le passage de vis sont formées sur le boîtier en matière plastique.

7. Boîtier en matière plastique suivant l'une des revendications 1 à 5, caractérisé par le fait que la paroi de boîtier (17) est réalisée, dans une zone inférieure (25) qui est prévue pour la liaison du boîtier en matière plastique (1) avec un substrat (5) en tant que surface de fond, avec une épaisseur au moins double de celle de la paroi de boîtier restante (17).

8. Module semi-conducteur de puissance comprenant un boîtier en matière plastique (1) suivant l'une des revendications 1 à 7, et un substrat céramique (5) qui est rapporté en tant que fond de boîtier dans le boîtier en matière plastique (1), le substrat (5) présentant au moins sur le côté tourné vers l'intérieur du boîtier, au moins sur des surfaces partielles, une couche métallique (7) sur laquelle est soudé un composant semi-conducteur de puissance (9).

9. Module semi-conducteur de puissance suivant la revendication 8, dans lequel des cosses de connexion (11) pour des connexions électriques du module sont en outre soudées sur la couche métallique (7), les cosses de connexion (17) présentant un cintre de dilatation (12) et les cosses de connexion (11) présentant une section réduite dans la zone du cintre de dilatation (12).

10. Module semi-conducteur de puissance suivant la revendication 8 ou 9, caractérisé par le fait que la couche métallique (10) est réalisée avec une épaisseur de quelques dizièmes de millimètre et est appliquée par un procédé de liaison directe sur le substrat céramique (5).

11. Module semi-conducteur de puissance suivant l'une des revendications 8 à 10, caractérisé par le fait que le substrat céramique (5) et le boîtier en matière plastique (1) sont reliés à une plaque de fond métallique (26) d'une épaisseur d'au moins 2 mm.

12. Module semi-conducteur de puissance suivant l'une des revendications 8 à 11, caractérisé par le fait que le module semi-conducteur de puissance est rempli d'abord à l'aide d'une masse de scellement souple (14) jusqu'à un premier niveau, de préférence jusqu'à mi-hauteur du boîtier, et est ensuite rempli à l'aide d'une masse de scellement dure (13) jusqu'à un second niveau, de préférence jusqu'au bord supérieur du boîtier.
